(19) Europäisches Patentamt
European Patent Office
Office européen des brevets

(11) **EP 4 120 359 A1**

(12) **DEMANDE DE BREVET EUROPEEN**

(43) Date de publication:
**18.01.2023 Bulletin 2023/03**

(21) Numéro de dépôt: **22183796.6**

(22) Date de dépôt: **08.07.2022**

(51) Classification Internationale des Brevets (IPC):
*H01L 29/417* (2006.01)  *H01L 21/265* (2006.01)
*H01L 29/08* (2006.01)  *H01L 29/20* (2006.01)
*H01L 29/66* (2006.01)  *H01L 29/778* (2006.01)
*H01L 29/423* (2006.01)

(52) Classification Coopérative des Brevets (CPC):
H01L 29/41766; **H01L 21/2654; H01L 29/0843;**
**H01L 29/66462; H01L 29/7786;** H01L 29/2003;
H01L 29/42316

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**KH MA MD TN**

(30) Priorité: **12.07.2021 FR 2107551**

(71) Demandeurs:
• **Commissariat à l'énergie atomique
et aux énergies alternatives
75015 Paris (FR)**

• **THALES
92400 Courbevoie (FR)**

(72) Inventeurs:
• **MORVAN, Erwan
38054 GRENOBLE CEDEX 09 (FR)**
• **BISCARRAT, Jérôme
38054 GRENOBLE CEDEX 09 (FR)**
• **GOBIL, Yveline
38054 GRENOBLE CEDEX 09 (FR)**

(74) Mandataire: **Cabinet Camus Lebkiri
25 rue de Maubeuge
75009 Paris (FR)**

(54) **TRANSISTOR À HAUTE MOBILITÉ ÉLECTRONIQUE À RESISTANCE D'ACCÈS RÉDUITE ET PROCÉDÉ DE FABRICATION D'UN TRANSISTOR À HAUTE MOBILITÉ ÉLECTRONIQUE AVEC RÉSISTANCE D'ACCÈS RÉDUITE**

(57) L'invention a pour un objet un transistor (400) à haute mobilité électronique comprenant :
• Un empilement de couches comprenant une couche de passivation (401) et une hétérojonction comprenant une première couche semi-conductrice (402), une deuxième couche semi-conductrice (403) et un gaz bidimensionnel d'électrons (404) à leur interface, une surface de la couche de passivation (401) étant au contact de la première couche semi-conductrice (402) ;
• Un contact métallique (405) de source et/ou un contact métallique de drain et une électrode de grille (406) ;
• Une zone dopée n+ (407) située à l'intérieur de l'hétérojonction ;
le contact métallique (405) de source et/ou le contact métallique de drain étant positionné au niveau d'un évidement formé dans l'empilement de couches, ledit contact métallique (405) de source et/ou ledit contact métallique de drain ayant une épaisseur définie par une face supérieure (405a) et une face inférieure (405b) sensiblement parallèles au plan de couches, la face supérieure (405a) étant plane, la face inférieure (405b) étant au contact de zone dopée n+ (407) et au-dessous de l'interface entre première couche semi-conductrice (401) et deuxième couche semi-conductrice (402), ledit contact métallique (405) de source et/ou ledit contact métallique de drain possédant en outre une face latérale (405c), la zone dopée n+ s'étendant depuis la face latérale du contact métallique (405) de source et/ou depuis la surface latérale du contact de drain vers l'électrode de grille (406) sur une longueur comprise entre 300 et 1000 nm.

Fig. 4

**Description**

**DOMAINE TECHNIQUE DE L'INVENTION**

L'invention appartient au domaine des transistors à effet de champ à haute mobilité électronique pour les applications haute fréquence. Un objet de l'invention est un transistor à haute mobilité électronique avec résistance d'accès réduite. Un autre objet de l'invention est un procédé de fabrication d'un tel transistor.

**ARRIERE PLAN TECHNOLOGIQUE DE L'INVENTION**

De nombreuses applications électroniques nécessitent des dispositifs fonctionnant à haute fréquence, par exemple au-dessus de la bande X ayant une fréquence autour de 10 GHz. Parmi ces dispositifs, on peut citer les amplificateurs de puissance, les amplificateurs bas-bruit, les oscillateurs ou encore les interrupteurs. De tels dispositifs peuvent être utilisés dans les radars, les télécommunications ou dans l'électronique embarquée à destination de l'automobile, des transports, de l'aéronautique ou encore dans des applications médicales ou dans la domotique.

Les dispositifs électroniques haute fréquence font souvent appel à des transistors à effet de champ à haute mobilité électronique (« High Electron Mobility Transistor » ou HEMT selon la terminologie anglaise). Ces transistors sont également désignés par transistors à effet de champ à hétérojonction. Un transistor HEMT comprend une superposition de deux couches semi-conductrices ayant des énergies de bandes interdites (ou énergies de gap selon la terminologie anglaise) différentes. Une telle superposition entraîne la formation d'un puits quantique à l'interface entre les deux couches. Le puits quantique confine les électrons pour former un gaz bidimensionnel d'électrons ou « 2-Dimensional Electron Gas », gaz 2DEG selon la terminologie anglaise. Par exemple la couche avec énergie de gap plus élevée ou couche barrière peut être en AlGaN. La couche avec énergie de gap moins élevée ou couche canal peut être en GaN.

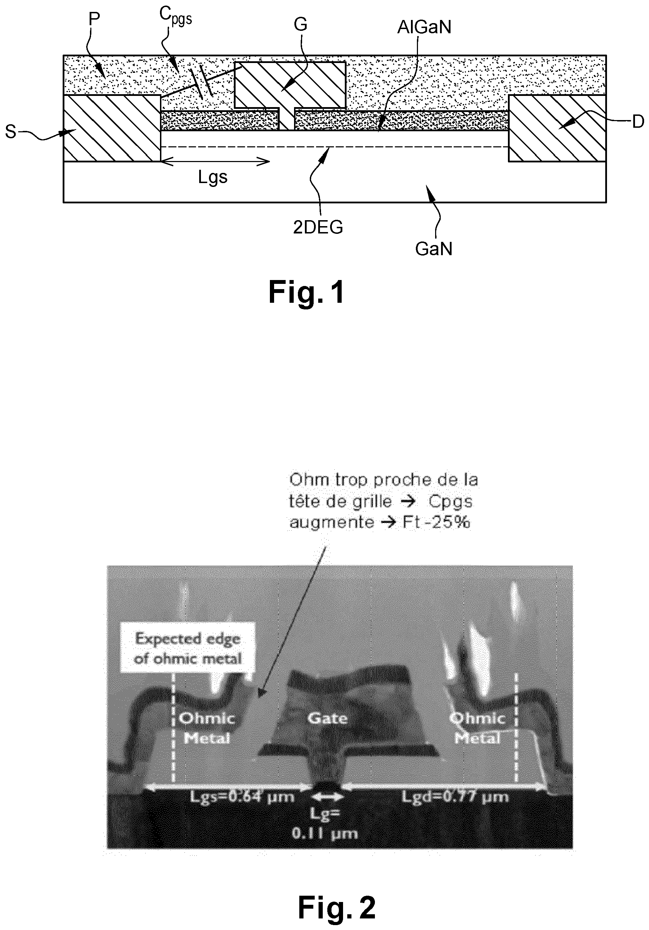

La figure 1 montre une vue en coupe schématique d'un transistor HEMT selon l'état de la technique. Le transistor HEMT inclut une hétérojonction comprenant une première couche semi-conductrice ou couche barrière en AlGaN et une deuxième couche semi-conductrice ou couche canal en GaN ainsi qu'une couche de passivation P au-dessus de la couche barrière. Un gaz bidimensionnel d'électrons 2DEG est formé à l'interface AlGAN/GaN. Le transistor de la figure 1 comprend en outre un contact de source S, un contact de drain D et une électrode de grille G. Le gaz 2DEG est connecté électriquement aux contacts de source S et drain D. L'électrode de grille G possède une forme en T, avec le pied de grille à proximité de la couche barrière en AlGaN. Le pied de grille est en contact direct avec la barrière dans le cas d'une grille de type Schottky ou avec un diélectrique très fin entre l'électrode de grille et la barrière dans le cas d'une grille de type Metal/Isolant/Semiconducteur ou MIS.

Les transistors HEMT doivent présenter une résistance de source ou résistance d'accès Rs la plus faible possible afin d'éviter une dégradation des performances intrinsèques du transistor, la résistance Rs étant définie comme la résistance entre le métal de source et le pied de la grille en T. En effet, la résistance de source dégrade la transconductance intrinsèque, la fréquence de transition et la fréquence maximale d'oscillation des transistors.

Il est important de considérer que Rs doit être minimale à la fois à la température ambiante et à la température de fonctionnement de l'accès du transistor. En puissance, un HEMT travaille à une température de jonction de 175°C à 225°C. Les zones d'accès sont donc à des températures supérieures à 100°C, par exemple à des températures comprises entre 100 et 150°C.

La résistance de source ou d'accès est la somme de plusieurs résistances dont les plus importantes sont :

- La résistance du contact ohmique : $R_c(T°)$
- La résistance du gaz 2DEG : $R_{2DEG}(T°)$ sur une longueur Lgs séparant le métal de source et le pied de grille. Cette résistance augmente d'un facteur environ 2.2 à 150°C.

Les techniques habituellement utilisées pour réduire la résistance de source sont les suivantes :

- améliorer la résistance de contact $R_c$ ;

- réduire la distance entre la grille et la source Lgs ; cette technique est limitée par la lithographie, les règles de dessin entre le contact de source et le pied de grille et par l'augmentation des capacités parasites grille-source Cpgs ;

- réduire la résistance de couche du 2DEG , $R_{2DEG}$ ; cette technique est non seulement limitée par les caractéristiques de l'hétérojonction mais aussi et surtout par le fait que cette résistance augmente fortement avec la température à cause de la dégradation de la mobilité des électrons ;

- introduire une couche très fortement dopée entre le contact et le 2DEG (couche n+).

Un exemple de transistor HEMT avec une faible résistance d'accès est divulgué dans le document "GaN-on-Si mm-wave RF Devices Integrated in a 200mm CMOS Compatible 3-Level Cu BEOL" de B.Parvais et al., IEDM 2020. La figure 2 montre une vue en coupe d'un tel dispositif selon l'état de l'art. Dans ce cas, l'accès du HEMT est un contact ohmique latéral ou « full recess » selon la terminologie anglaise. Cette approche permet un contact direct entre le 2DEG et le métal de contact ohmique à l'aide d'une gravure de la couche de passivation et de la barrière. Une telle gravure de la couche de passivation et de la couche barrière est également appelée recess.

Cette technique permet d'obtenir une bonne résistance de contact ohmique, de l'ordre de 0.3 Ohm.mm. Le métal du contact ohmique de l'accès est réalisé par dépôt et gravure et doit déborder de l'ouverture du contact. Comme le montre la Figure 2, un tel contact ne permet pas de rapprocher suffisamment le contact ohmique du pied de la grille en T, avec une distance $L_{gs}$ de 0.64$\mu$m. De plus, cette approche présente une difficulté technologique au niveau de la gravure du métal ohmique. En effet le débordement excessif du métal ohmique du contact conduit à une capacité grille-source parasite $C_{pgs}$. Cela entraine une dégradation importante de la fréquence de transition, avec une réduction autour de 25%. Cela empêche l'utilisation de ce dispositif dans le domaine milimétrique ou à haute fréquence.

Par ailleurs, la résistance du 2DEG est alors de l'ordre de 0.3 Ohm.mm à température ambiante et supérieure à 0.6 Ohm.mm à la température de fonctionnement, ce qui pénalise fortement la résistance d'accès de source pendant l'utilisation du dispositif.

Cette technologie n'est donc pas adaptée à la réalisation d'un accès de source très compact pour des composants haute fréquence.

Un autre exemple de transistor HEMT ayant une faible résistance d'accès est décrit dans le document "Scaling of GaN HEMTs and Schottky Diodes for Submillimeter-Wave MMIC Applications" de Keisuke Shinohara et al., publié dans IEEE TRANSACTIONS ON ELECTRON DEVICES, Vol. 60, No. 10, 2013.

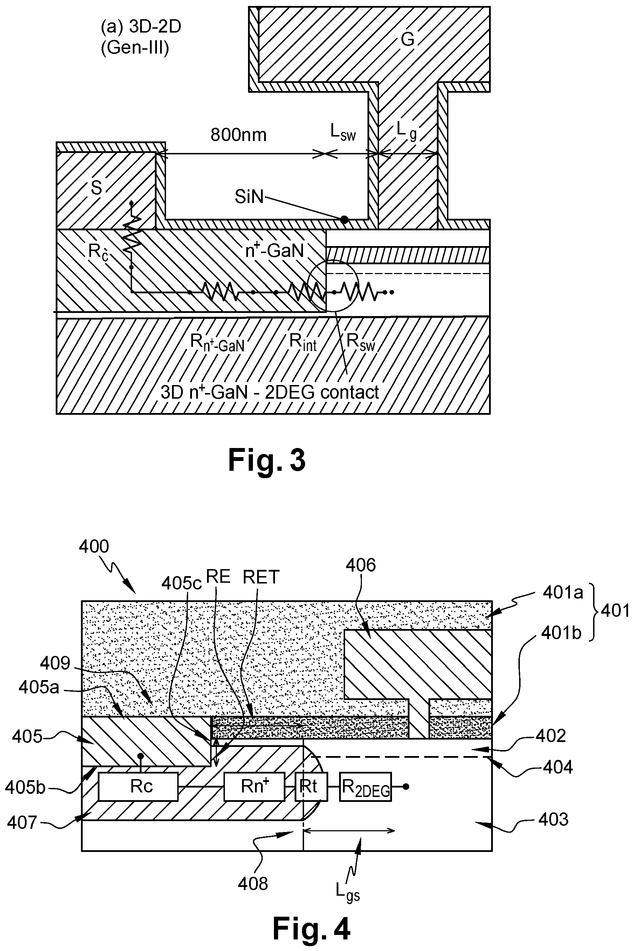

La figure 3 illustre une vue en coupe schématique d'un tel dispositif de l'état de l'art. Dans ce cas, le contact est réalisé en trois étapes. L'hétérostructure AlGaN/GaN est tout d'abord gravée, puis une couche de GaN fortement dopée n+ est ré-épitaxiée localement dans la zone gravée. Enfin, un contact métallique est réalisé sur le GaN n+.

Ce type d'accès présente une très bonne performance mais est difficile à réaliser car il nécessite :

- un excellent contrôle de la gravure de la barrière ; la qualité de la ré-épitaxie de GaN n+ sur le fond et le flanc de gravure est très dépendante de la morphologie du fond de gravure ;

- une ré-introduction du wafer dans un équipement pour épitaxie en phase vapeur aux organométalliques ou « metalorganic chemical vapor déposition » MOCVD, selon la terminologie anglaise ; cela est nécessaire pour l'épitaxie de matériau semiconducteur III-N associant des atomes de la colonne III de la classification périodique des éléments avec l'azote N, ce qui rend difficile la compatibilité avec une salle blanche de type CMOS à cause des possibles contaminations et augmente le coût ;

- une croissance de matériau GaN localisée dont le masquage est difficile à réaliser.

Même si cette technique est très performante, elle est très difficile à intégrer dans un procédé industriel bas coût et dans une salle blanche compatible CMOS.

Un homme du métier ne connaît pas donc de transistor HEMT avec faible résistance d'accès qui soit adapté pour des applications haute fréquence et simple à fabriquer. En d'autres termes, il n'existe pas aujourd'hui de transistor HEMT à très faible résistance d'accès pour des composants de puissance haute fréquence (>30 GHz) obtenu à l'aide d'un procédé industriel bas coût et réalisable dans une salle blanche compatible CMOS.

**RESUME DE L'INVENTION**

L'invention vise à résoudre au moins partiellement les problèmes mentionnés ci-dessus en proposant un transistor HEMT ayant une très faible résistance d'accès et une capacité parasite source-grille et/ou drain-grille réduite, tout en étant très compact. De plus, le transistor HEMT selon l'invention montre un excellent comportement en température ce qui le rend particulièrement bien adapté pour des applications de puissance haute fréquence.

A cette fin, un objet de l'invention porte sur un transistor à haute mobilité électronique comprenant :

- un empilement de couches comprenant une couche de passivation et une hétérojonction comprenant une première couche semi-conductrice, une deuxième couche semi-conductrice et un gaz bidimensionnel d'électrons à leur interface, une surface de la couche de passivation étant au contact de la première couche semi-conductrice ;

- un contact métallique de source et/ou un contact métallique de drain et une électrode de grille ;

- une zone dopée n+ située à l'intérieur de l'hétérojonction ;

le contact métallique de source et/ou le contact métallique de drain étant positionné au niveau d'un évidement formé dans l'empilement de couches, ledit contact métallique de source et/ou ledit contact métallique de drain ayant une épaisseur définie par une face supérieure et une face inférieure sensiblement parallèles au plan des couches, la face supérieure étant plane, la face inférieure étant au contact de la zone dopée n+ et au-dessous de l'interface entre la première couche semi-conductrice et la deuxième couche semi-conductrice, ledit contact métallique de source et/ou ledit contact métallique de drain possédant en outre une face latérale, la zone dopée n+ s'étendant depuis la face latérale du contact métallique de source et/ou depuis la face latérale du contact métallique de drain vers l'électrode de grille sur une longueur comprise entre 300 et 1000 nm.

Dans ce qui suit, l'invention est décrite par rapport au contact métallique de source. Toutefois chaque caractéristique du contact métallique de source peut également se référer au contact métallique de drain ou aux deux contacts métalliques de source et drain. En d'autres termes, le transistor selon l'invention peut avoir une très faible résistance d'accès de source, une très faible résistance d'accès de drain ou une très faible résistance de source et de drain. On entend par zone dopée n+ une région de l'hétérojonction dopée n+ par implantation ionique. On entend par dopage n+, un fort dopage n (i.e. avec une concentration de donneurs supérieure à $10^{19}$ cm$^{-3}$ et préférentiellement supérieure à $10^{20}$ cm$^{-3}$). La zone dopée n+ permet de réduire l'extension du gaz bidimensionnel d'électrons compris entre le contact métallique de source et l'électrode de grille tout en éloignant ledit contact métallique de source de l'électrode de grille. En d'autres termes, le contact métallique de source se trouve en retrait par rapport à l'extrémité de la zone dopée n+, le retrait étant la distance entre la face latérale du contact de source la plus proche de l'électrode de grille et l'extrémité de la zone dopée n+.

Grâce à l'invention, la résistance de couche de la zone dopée n+ est inférieure à la résistance du gaz bidimensionnel d'électrons et beaucoup moins sensible à la température et la réduction de l'extension du gaz bidimensionnel d'électrons permet de réduire la résistance d'accès du contact de source.

Le retrait du contact métallique de source par rapport à la grille permet de réduire la capacité parasite entre contact de source et électrode de grille, ce qui rend le transistor selon l'invention très bien adapté au régime haute fréquence.

Le contact électrique entre le contact métallique de source et le gaz bidimensionnel d'électrons est réalisé grâce au fait que la face inférieure du contact de source est au contact de la zone dopée n+. En d'autres termes, le contact de source forme un recess ou une niche s'étendant au-dessous de l'interface entre la première couche semi-conductrice ou couche barrière et la deuxième couche semi-conductrice ou couche canal.

Dans un transistor selon l'invention, la résistance de contact entre la face inférieure du contact de source et la zone dopée n+ est très faible et très peu sensible à la température de fonctionnement, ce qui permet de réduire la résistance d'accès de source.

On entend par face supérieure plane du contact métallique une surface métallique ayant une épaisseur uniforme et une surface sans déformations telles que des bosses ou des trous. La planéité de la surface permet de « raboter » le métal du contact de source et éviter son extension latérale. La planéité de la surface permet en outre d'avoir un contrôle optimal de la lithographie ultérieure du pied de grille et donc un excellent contrôle des formes lithographiées et de leur positionnement.

La face supérieure plane du contact permet d'obtenir un contact compact, fin et sans débordements en réduisant ultérieurement les capacités parasites entre le contact de source et la grille.

De plus, on constate que l'accès de source est performant et très peu sensible à la température de fonctionnement du transistor selon l'invention.

Le transistor selon l'invention peut également présenter une ou plusieurs des caractéristiques ci-dessous, considérées individuellement ou selon toutes les combinaisons techniquement possibles :

- la zone dopée n+ est une zone implantée possédant un profil spatial de dopage de type gaussien selon la direction normale au plan des couches ;

- la face inférieure du contact métallique de source et/ou la face inférieure du contact métallique de drain est au-dessous du gaz bidimensionnel d'électrons ;

- la face inférieure du contact métallique de source et/ou la face inférieure di contact métallique de drain est au niveau du pic du profil spatial de dopage de type gaussien selon la direction normale au plan des couches ;

- la distance Lgs entre l'électrode de grille et l'extrémité de la zone dopée n+ est comprise entre 200 nm et 400 nm ;

- la zone dopée n+ est dopée avec un dopant de type Si ou Ge avec une concentration supérieure ou égale à $10^{20}$ cm$^{-3}$ ;

- la première couche semi-conductrice comprend du AlGaN et la deuxième couche semi-conductrice comprend du GaN ;

- la première couche semi-conductrice comprend un matériau choisi dans le groupe comprenant : AlGaN, AlN, In-GaAlN, ScAlN ;

- la première couche semi-conductrice est une bicouche choisie dans le groupe de bicouches comprenant : Al-GaN/AlN, AlGaN/GaN,InAlN/AlN, InGaAlN/AlN, ou ScAlN/AlN.

- La deuxième couche semi-conductrice est en GaN ou AlGaN ;

- le transistor comprend en outre un contact de drain ayant la même structure que le contact de source.

Un autre objet de l'invention est un procédé de fabrication d'un transistor à haute mobilité électronique comprenant les étapes suivantes :

- fourniture d'un substrat de transistor à haute mobilité d'électrons comprenant un empilement de couches comprenant une couche de passivation et une hétérojonction comprenant une première couche semi-conductrice, une deuxième couche semi-conductrice et un gaz bidimensionnel d'électrons à leur interface ;

- formation d'une zone dopée n+ par implantation ionique à l'intérieur de l'hétérojonction et recuit d'activation de la zone dopée n+ ;

- dépôt d'une couche diélectrique au contact de la couche de passivation ;

- gravure de l'empilement de couches et de la couche diélectrique pour former un évidement à l'aplomb et au contact de la zone dopée n+, ledit évidement étant adapté pour accueillir un contact métallique de source et/ou drain, la face inférieure de l'évidement se situant au-dessous de l'interface entre la première couche semi-conductrice et la deuxième couche semi-conductrice;

- dépôt d'une couche métallique destinée à former le contact métallique de source et/ou le contact métallique de drain ;

- polissage mécano-chimique de la couche métallique pour obtenir une surface supérieure du contact de source et/ou une surface supérieure du contact de drain planarisée ;

- définition et dépôt d'une électrode de grille, la zone dopée n+ s'étendant depuis une face latérale du contact métallique de source et/ou depuis une face latérale du contact métallique de drain vers l'électrode de grille sur une longueur comprise entre 300 et 1000 nm.

Le procédé selon l'invention permet d'obtenir une zone dopée n+ assurant un contact électrique très performant qui réduit la résistance d'accès du transistor.

Le procédé selon l'invention est fiable, précis, uniforme, reproductible et réalisable dans une salle blanche compatible CMOS.

Un exemple de substrat de transistor à haute mobilité électronique utilisé dans le procédé selon l'invention comprend un substrat Si <111 > à haute résistivité, une couche de nucléation en AlN, une couche de gestion des contraintes, une couche tampon en GaN ou en AlGaN à faible taux d'Al, une couche barrière de confinement, une couche canal en GaN et une couche barrière en AlGaN.

Le procédé selon l'invention peut également comprendre une ou plusieurs des étapes ci-dessous, considérées individuellement ou selon toutes les combinaisons techniquement possibles :

- l'étape de formation de la zone dopée n+ comprend une implantation mono énergétique de ions Si ou Ge, avec une énergie d'implantation comprise entre 60 keV et 80 keV (pour le Si) ;
- le recuit d'activation de la zone dopée n+ comprend un traitement thermique à 975°C pendant 10h, 1000 °C pendant trois heure ou à 1050 °C pendant une heure ;
- le procédé comprend en outre une étape de photolithographie pour définir une zone d'implantation destinée à accueillir la zone dopée n+ ;

- l'implantation mono énergétique d'ions Si ou Ge comporte la création d'une zone dopée n+ ayant un profil spatial de dopage de type gaussien selon la direction normale au plan des couches. L'utilisation d'implantations à plusieurs énergies ne permet pas d'atteindre la performance visée ;
- l'étape d'implantation n'est réalisée que pour le contact de source ;
- l'étape d'implantation est réalisée à la fois pour le contact de source et pour le contact de drain.

**BREVE DESCRIPTION DES FIGURES**

D'autres caractéristiques et avantages de l'invention ressortiront clairement de la description qui en est donnée ci-dessous, à titre indicatif et nullement limitatif, en référence aux figures annexées, parmi lesquelles :

La figure 1 illustre une vue en coupe schématique d'un transistor HEMT selon l'art antérieur ;

La figure 2 représente une image TEM d'un transistor HEMT selon l'art antérieur et comportant un contact de type « full-recess » avec métal débordant ;

La figure 3 représente une vue en coupe schématique d'un transistor HEMT selon l'art antérieur et comportant un contact de source ou drain réalisé par gravure et re-épitaxie ;

La figure 4 représente une vue en coupe schématique d'une partie d'un transistor HEMT selon l'invention ;

La figure 5 représente une coupe TEM d'un transistor selon l'invention ;

La figure 6 représente le profil d'implantation d'ions Si selon un mode de réalisation du transistor selon l'invention ;

La figure 7 illustre schématiquement le procédé selon l'invention ;

Les figures 8a à 8p illustrent les résultats des différentes étapes du procédé selon l'invention de la figure 7 ;

La figure 9 illustre la variation de la résistance de contact effective du transistor, $R_C$ en fonction de la variation de température de fonctionnement du dispositif selon l'invention ;

La figure 10 illustre la variation de la résistance de transition $R_T$ en fonction de la température de fonctionnement du dispositif selon l'invention ;

La figure 11 illustre la variation de la résistance de la zone dopée n+ en fonction de la température de fonctionnement du dispositif selon l'invention ;

La figure 12 illustre la variation de la résistance de contact métal/GaN dopé n+ en fonction de la température de fonctionnement du dispositif selon l'invention.

**DESCRIPTION DETAILEE DE L'INVENTION**

La figure 3 représente une vue en coupe schématique d'un transistor 400 à haute mobilité électronique selon l'invention. En particulier, la figure 3 représente la partie du transistor 400 comprenant un contact de source 405 et une électrode de grille 406. Le transistor 400 selon l'invention comprend un empilement de couches comprenant une couche de passivation 401 et une hétérojonction comprenant une première couche semi-conductrice 402 et une deuxième couche semi-conductrice 403.

La première couche semi-conductrice 402 possède une énergie de gap plus élevée que la deuxième couche semi-conductrice 403. La première couche semi-conductrice 402 est également appelée couche barrière ou barrière. La deuxième couche semi-conductrice 403 est également appelée couche canal ou canal. Un gaz bidimensionnel d'électrons ou 2DEG 404 est formé à l'interface entre la couche barrière 402 et la couche canal 403. La couche de passivation 401 est au contact de la première couche semi-conductrice 402.

Selon un mode de réalisation, la couche de passivation 401 est une bicouche comprenant des couches 401a et 401b. Selon un mode de réalisation les couches 401a et 401b sont réalisées respectivement en $SiO_2$ et SiN.

Le transistor 400 selon l'invention comporte en outre le contact métallique 405 de source, un contact métallique de drain non représenté et l'électrode de grille 406. La figure 4 représente seulement le contact de source. L'électrode de grille 406 est positionnée entre les contacts métalliques de source et drain. Selon un mode de réalisation l'électrode de grille 406 peut avoir une forme en T, avec un pied de grille à proximité de la couche barrière 402.

En d'autres termes, la figure 4 représente la moitié de la structure du transistor 400 selon l'invention, le contact de drain n'étant pas représenté. Selon un mode de réalisation de l'invention, le transistor 400 est symétrique avec un contact de drain identique au contact de source. La distance grille-drain est supérieure ou égale à la distance grille-source.

Le transistor 400 selon l'invention comprend en outre une zone dopée n+ 407 se situant à l'intérieur de l'hétérojonction. En d'autres termes, une extrémité 408 de la zone dopée n+ 407 est positionnée entre le contact métallique de source 405 ou drain et le pied de grille.

La zone dopée n+ 407 est obtenue par implantation ionique d'un dopant de type n.

Selon le mode de réalisation représenté à la figure 4, la couche barrière 402 est en AlGaN, la couche canal 403 en GaN et la zone dopée n+ 407 est obtenue grâce à une implantation de Silicium localisée à profil gaussien. L'implantation ionique est associée à un recuit d'activation optimisé, 975°C pendant 10h, 1000°C pendant 3 heures ou 1050°C pendant une heure, pour former une zone dopée n+ et un contact performant.

Selon un mode de réalisation, l'hétérojonction est une hétérostructure de type III-N à base d'Al, In ou Ga. Des exemples de telles hétérostructures sont AlGaN/AlN/GaN, AlGaN/GaN, InGaAlN/AlN/GaN,ou AlGaN/AlN/AlGaN dans laquelle le canal est en AlGaN.

Selon un mode de réalisation, l'hétérojonction est une hétérostructure de type III-N à base de ScAlN. Des exemples de telles hétérostructures sont ScAlN/GaN ou ScAlN/AlN/GaN.

Le contact métallique 405 de source ou drain est situé au niveau d'un évidement 409 formé dans l'empilement de couches. Le contact métallique 405 possède une épaisseur définie par une face supérieure 405a du contact métallique et une face inférieure 405b du contact métallique. Les deux faces inférieure et supérieure du contact métallique 405 sont sensiblement parallèles aux plans des couches.

La face supérieure 405a est plane de façon à réduire les capacités parasites entre l'électrode de grille 406 et le contact métallique 405 de source ou drain. En d'autres termes, l'épaisseur du contact 405 de source ou drain est constante sur toute la région du contact 406. De façon équivalente, l'épaisseur du contact 405 est égale à l'épaisseur de l'évidement.

La disposition de la face supérieure 405a du contact métallique 405 permet de réaliser un contact très compact, fin et sans débordement et ainsi de réduire au maximum les capacités parasites $C_{pgs}$ entre le métal du contact 405 et le métal de grille. La planarisation permet aussi d'améliorer le contrôle des lithographies suivantes.

La face inférieure 405b est au contact de la zone implantée dopée n+ 407. En d'autres termes, le contact métallique 405 forme un recess RE par rapport à la surface de la couche barrière 402 et la face inférieure 405b du contact 405 est au-dessous de l'interface entre la première couche semi-conductrice 402 et la deuxième couche semi-conductrice 403.

Le recess RE sous la couche barrière 402 permet de réduire la résistance de contact métal/couche semiconductrice $R_c$ à des valeurs très faibles de l'ordre de 50-70 mOhm.mm. Cela est possible en positionnant le métal ohmique sur la zone canal dopée n+ 407 et non sur la couche barrière 402 qui présente un gap plus grand. La profondeur minimale du recess RE doit être telle que le métal ohmique soit déposé en surface de la zone dopée n+ 407 ou au maximum à la profondeur du pic du profil d'implantation de la zone dopée n+ 407.

Le contact 405 comprend en outre une face latérale 405c sensiblement normale au plan des couches. La distance RET entre la face latérale 405c et l'extrémité 408 de la zone dopée n+ 407 est comprise entre 300 nm et 1000 nm. En d'autres termes, le contact métallique 405 est en retrait par rapport à l'extrémité 408 de la zone dopée n+ 407.

La résistance de couche $R_{sheet}$ associée à la zone implantée n+ 407 est très faible et inférieure à 60-90 ohm/sq. Cela permet d'éloigner le contact métallique 405 de l'électrode de grille 406 sans augmenter sensiblement la résistance d'accès. En particulier, la couche n+ est au moins trois fois plus performante que le 2DEG à température ambiant et cinq fois plus performante à 100°C. Le retrait RET doit être suffisamment grand pour limiter la capacité parasite $C_{pgs}$ et suffisamment petit pour éviter d'augmenter la résistance de la couche n+.

Selon un mode de réalisation, la distance RET est comprise entre 300 nm et 1000 nm. La distance RET est ici égale à 500 nm.

La résistance de transition Rt entre la région implantée et la région intrinsèque est faible grâce à une implantation ionique optimisée de Si.

Selon un mode de réalisation, l'implantation est mono-énergétique de 70 kV/3-5*$10^{15}$/cm$^2$ à travers une couche de surface de 30 nm. L'utilisation d'une implantation multi-énergies, habituelle dans les semi-conducteurs à grand gap pour générer des caissons dopés, ne présenterait pas des résultats similaires car elle conduirait à une résistance Rt élevée.

La distance $L_{gs}$ entre l'extrémité 408 de la zone dopée n+ 407 et le pied de grille doit être suffisamment grande pour ne pas dégrader la tenue en tension de la jonction grille-source ou grille-drain. Selon un mode de réalisation, $L_{gs}$ est supérieure ou égale à 200 nm.

L'implantation Si présente une dispersion latérale qui ne doit pas trop se rapprocher du pied de grille. $L_{gs}$ doit être suffisamment petite pour limiter la contribution du gaz 2DEG à $R_s$, par exemple $L_{gs}$ doit être inférieure à 400 nm.

Selon un mode de réalisation, $L_{gs}$ est égale à 300nm.

Selon un mode de réalisation le contact métallique 405 comprend une bicouche Ti/Al avec une épaisseur de la couche en Ti comprise entre 3nm et 20nm et une épaisseur totale égale à 200nm +/- 50nm.

La figure 4 représente aussi la répartition des résistances d'accès de source ou de drain : la résistance de contact $R_c$, la résistance de la région implantée n+ $R_{n+}$, la résistance de transition $R_T$ et la résistance du gaz bidimensionnel d'électrons 2DEG, $R_{2DEG}$.

La résistance d'accès $R_s$ d'un contact de source du transistor 400 selon l'invention vaut à température ambiante, T = 30°C :

$$R_s = R_c + R_{n+} + R_t + R_{2DEG} = 0.3 \ Ohm.mm \ ;$$

$$A \ T = 150°C : \quad R_s = R_c + R_{n+} + R_t + R_{2DEG} = 0.35 \ Ohm.mm$$

On constate que l'accès d'un transistor 400 selon l'invention est performant et très peu sensible à la température grâce :

- à la faible longueur $L_{gs}$ réalisable, de l'ordre de 300 nm ;
- à la compensation de R2DEG(T°) par $R_t$(T°)

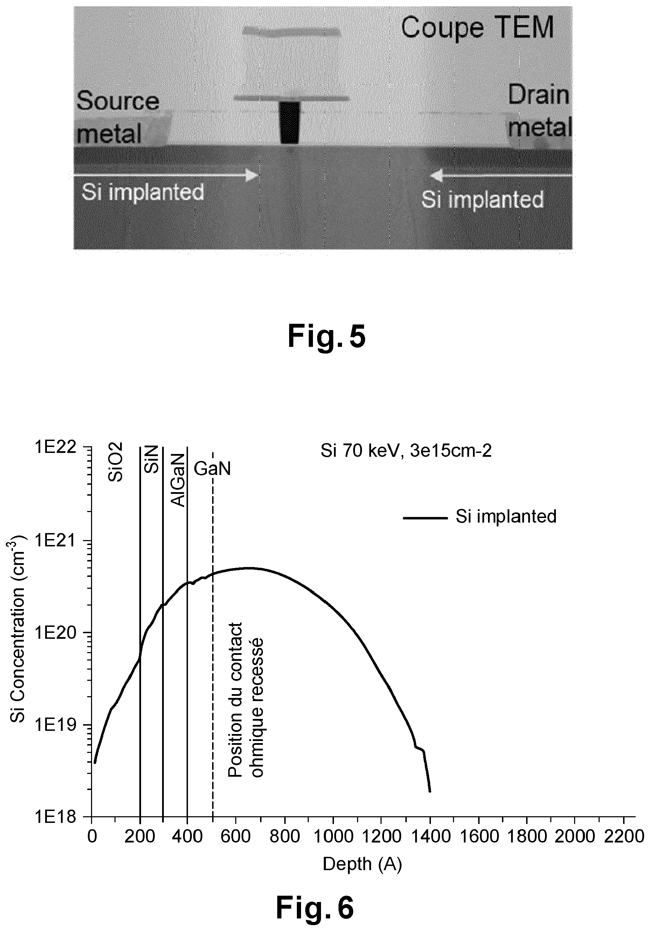

Le transistor 400 selon l'invention est obtenu par un procédé planaire et compatible avec une fabrication en salle blanche de type CMOS. La figure 5 représente une coupe TEM d'un transistor 400 selon l'invention. Le contact de source et le contact de drain sont tous les deux visibles sur la figure 5.

La figure 6 représente le profil d'implantation de Si en fonction de la profondeur selon une direction normale au plan des couches. Le profil d'implantation a été obtenu pour une énergie de 70 keV et une dose de $3*10^{15}/cm^2$ à travers la couche de passivation 401 de surface formée par une bicouche $SiO_2$/SiN. La position de l'interface du contact ohmique metal/GaN n+ est représentée par la ligne pointillée. Le profil présente une profondeur de pénétration projetée Rp, pour « Projected Range » selon la terminologie anglaise, de 64.5nm, une dispersion sigma de 23 nm et une extension latérale de 40 nm. L'extension latérale représente le débordement latéral du profil sous le masque.

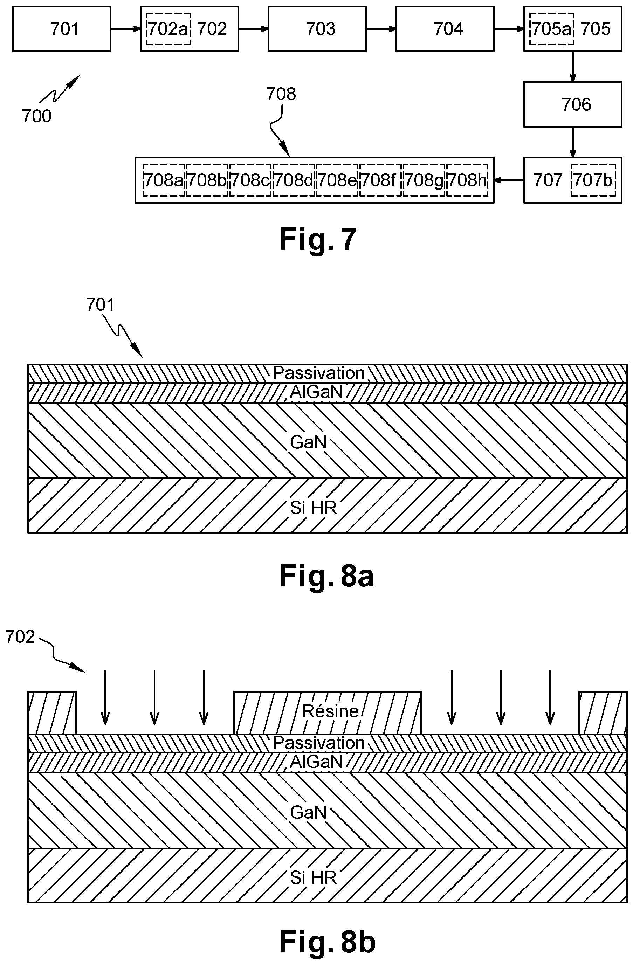

La figure 7 représente schématiquement le procédé 700 selon l'invention. Les étapes du procédé 700 selon l'invention sont illustrées aux figures 8a à 8p.

Le procédé 700 selon l'invention comprend une étape 701 de fourniture d'un substrat de transistor à haute mobilité d'électrons comprenant un empilement de couches comprenant une couche de passivation et une hétérojonction comprenant une première couche semi-conductrice et une deuxième couche semi-conductrice formant un gaz bidimensionnel d'électrons à leur interface. Un exemple de substrat de transistor à haute mobilité électronique utilisé lors de l'étape 701 est illustré à la figure 8a. Selon un mode de réalisation, le substrat de transistor à haute mobilité électronique comprend un substrat Si <111> à haute résistivité, une couche de nucléation en AlN, une couche de gestion des contraintes, une couche tampon en GaN ou en AlGaN à faible taux d'Al, une couche barrière de confinement, une couche canal en GaN et une couche barrière en AlGaN. Selon un autre mode de réalisation, le substrat de transistor à haute mobilité électronique comprend un substrat en Sic ou en GaN à la place su substrat en Si. Dans le cas d'un substrat en GaN, l'épitaxie est réalisée au départ sur un wafer en GaN.

Dans le cas de la figure 8a, la première couche semi-conductrice est en AlGaN et la deuxième couche semi-conductrice est en GaN. L'empilement de la figure 8a comprend en outre un substrat en Si à haute résistance HR.

L'étape 702 comprend l'implantation ionique d'un dopant de type n, illustrée à la figure 8b. Dans l'exemple illustré à la figure 8b l'implantation est réalisée symétriquement dans deux zones différentes correspondant au contact de source et au contact de drain.

Selon un mode de réalisation, l'étape d'implantation ionique 702 est précédée par une étape de photolithographie 702a pour la définition d'une zone d'implantation. L'étape de photolithographie est connue de l'homme du métier.

Selon un mode de réalisation, le dopant est du Silicium ou du Germanium.

Selon un mode de réalisation, l'étape 702 comprend une implantation mono-énergétique d'ions Si de 70 kV/3-5*$10^{15}/cm^2$ à travers une couche de surface de 30 nm. Un profil d'implantation selon l'invention est décrit à la figure 6. L'utilisation d'une implantation multi-énergies, habituelle dans les semi-conducteurs à grand gap pour générer des caissons dopés, n'est pas la plus adaptée car elle conduit à une résistance de transition Rt élevée.

Le procédé 700 comprend en outre une étape 703 de recuit du dopant. Selon un mode de réalisation, le dopant est du Si et le recuit peut être réalisé à 975°C pendant 10 heures, 1000°C pendant trois heures ou à 1050°C pendant une heure.

Un recuit long et à basse température permet d'éviter la déformation plastique des wafer GaN/Si.

Le Si est un dopant n+ très adapté à la réalisation d'une zone dopée n+ localisée :

- Il est activable à basse température dans les composés III-N tels que AlN, AlGaN ou GaN ;

- Il possède une solubilité supérieure à $4*10^{20}/cm^3$ permettant un dopage très élevé, par exemple supérieure à $10^{20}/cm^3$ et une diffusion négligeable ;

- Il s'agît d'un élément compatible avec les technologies CMOS et planar.

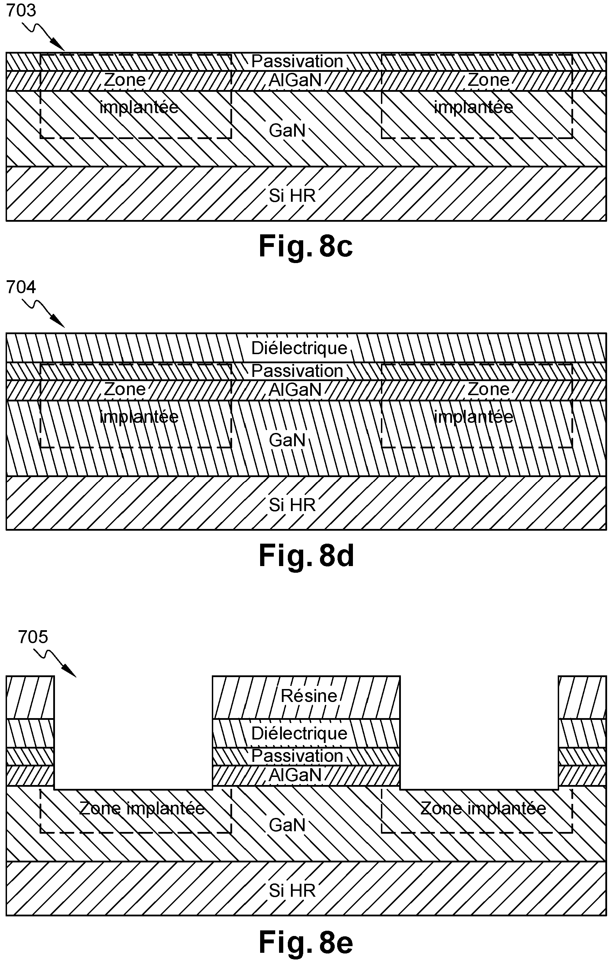

Selon un mode de réalisation, l'étape de recuit 703 est précédée par le retrait de la résine utilisée pour l'étape de lithographie. L'étape 703 de retrait de la résine et de recuit du dopant est illustrée à la figure 8c.

Le procédé 700 selon l'invention comprend en outre une étape 704 de dépôt d'une couche diélectrique au contact de la couche de passivation. L'étape 704 de dépôt d'une couche diélectrique est illustrée à la figure 8d.

Le procédé 700 comprend une étape de gravure 705 de l'empilement de couches et de la couche diélectrique pour former un évidement à l'aplomb et au contact de la zone implantée, ledit évidement étant destiné à accueillir un contact métallique de source ou drain, la distance séparant une extrémité de la zone implantée et une paroi latérale de l'évidement étant comprise entre 300 nm et 1000 nm, la face inférieure de l'évidement se situant au-dessous de l'interface entre la première et la deuxième couche semi-conductrice. Selon un mode de réalisation, l'étape de gravure 705 comprend une étape 705a de photolithographie pour définir la région à graver.

L'étape 705 de photolithographie et de gravure de l'empilement est illustrée à la figure 8e.

Selon un mode de réalisation, la gravure réalisée lors de l'étape 705 est une gravure sèche.

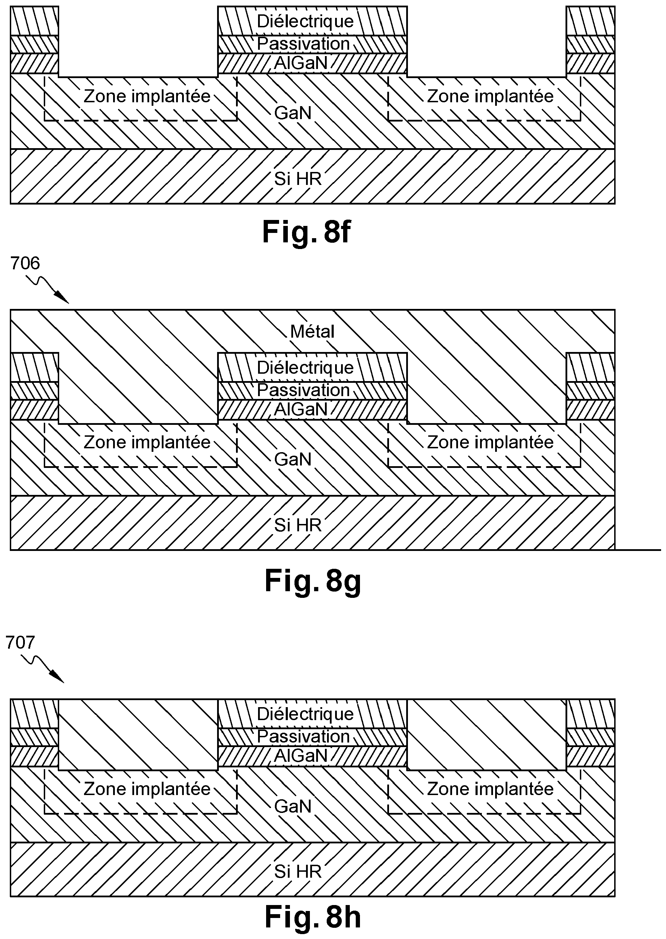

Selon un mode de réalisation, l'étape de gravure 705 comprend également le retrait de la résine utilisée lors de la sous-étape de photolithographie. L'empilement de couches obtenu après le retrait de la résine est illustré à la figure 8f.

Le procédé 700 selon l'invention comprend en outre une étape 706 de dépôt d'une couche métallique destinée à former le contact de source ou drain suivie par une étape 707 de polissage mécano-chimique de la couche métallique pour obtenir une surface supérieure du contact métallique de source ou drain planarisée.

L'étape 706 est également illustrée à la figure 8g. Le résultat de l'étape 707 de polissage mécano-chimique de la couche métallique est illustré à la figure 8h. Selon un mode de réalisation, l'étape 706 comprend le dépôt d'une bicouche métallique Ti/Al avec une épaisseur de la couche en Ti comprise entre 3nm et 20nm et une épaisseur totale égale à 200nm +/- 50nm.

Selon un mode de réalisation, l'étape 707 comprend en outre une sous-étape 707b de recuit du métal. A l'issue de l'étape 707 un contact métallique ayant une surface planarisée est obtenue.

L'étape 707 permet de réduire la capacité parasite entre le métal du contact et l'électrode de grille et optimiser la lithographie suivante.

Le procédé 700 comprend en outre une étape 708 de définition et dépôt d'une électrode de grille.

Selon un mode de réalisation, l'étape 708 comprend en outre les sous-étapes :

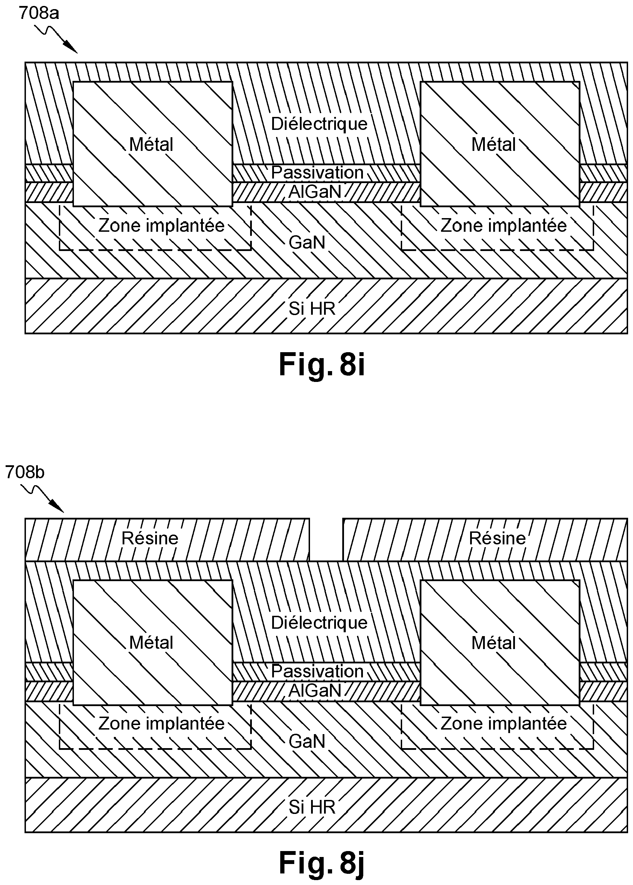

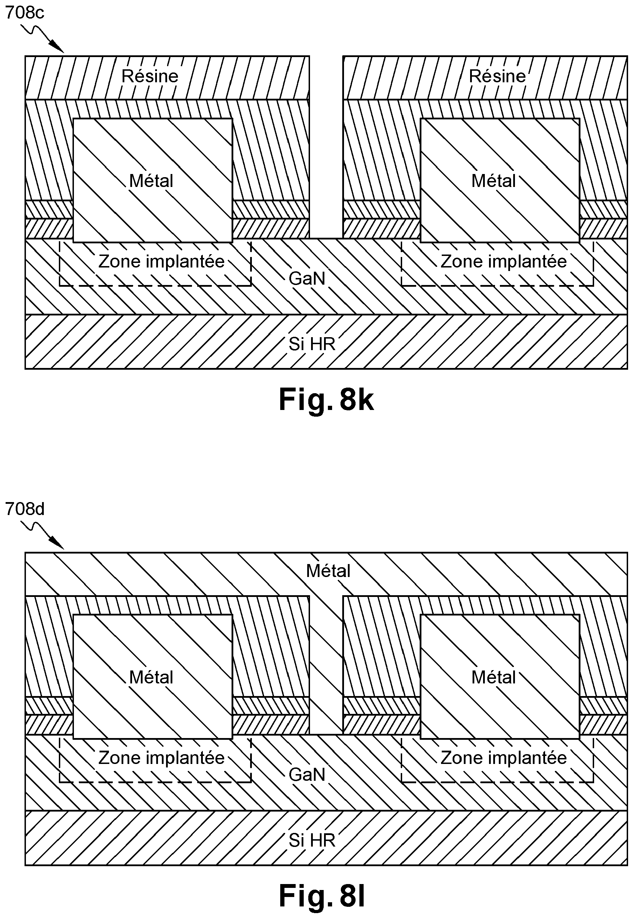

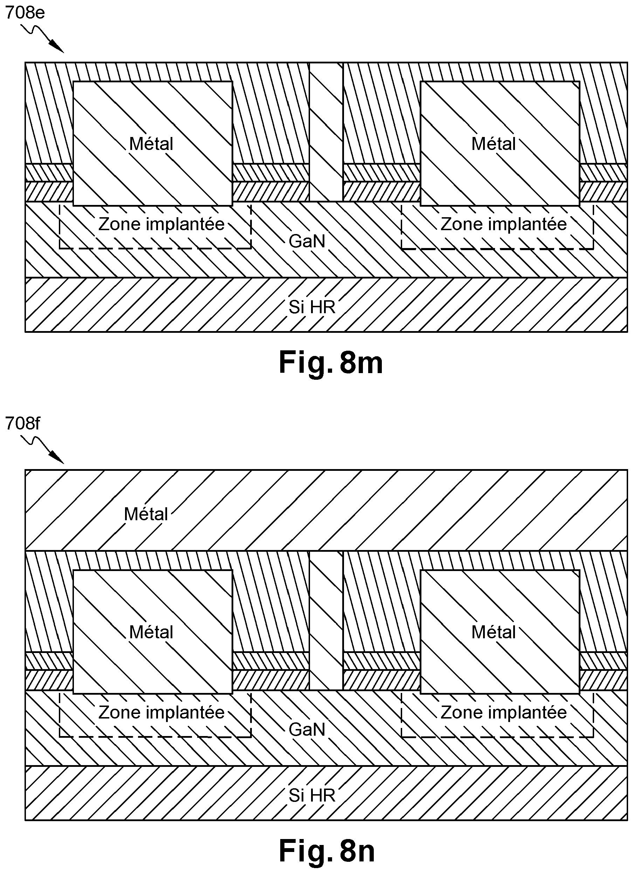

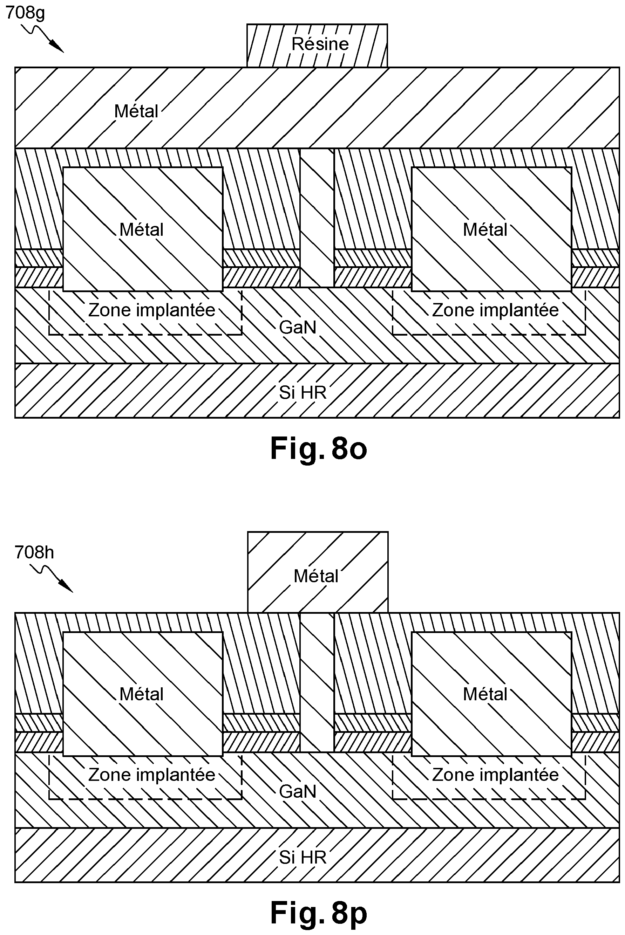

- 708a de dépôt d'une couche diélectrique ; l'étape 708a est illustrée à la figure 8i ;
- 708b de photolithographie pour définir le pied de grille ; l'étape 708b comprenant le dépôt d'une couche de résine est illustrée à la figure 8j ;
- 708c de gravure du pied de grille et retrait de la résine utilisée lors de l'étape 708b de photolithographie pour définir le pied de grille ; l'étape 708c est illustrée à la figure 8k ;
- 708d de dépôt d'un métal utilisé pour l'électrode de grille ; l'étape 708d est illustrée à la figure 8l ;
- 708e de polissage du métal utilisé pour le pied de grille ; l'étape 708e est illustré à la figure 8m ;
- 708f de dépôt d'une couche métallique destinée à former la tête de grille ; l'étape 708f est illustré à la figure 8n ;
- 708g de photolithographie pour définir la tête de grille ; l'étape 708g est illustrée à la figure 8o ;
- 708h de gravure du métal de tête de grille en excès et retrait de la résine utilisée pour définir la tête de grille ; l'étape 708g est illustrée à la figure 8p.

Le procédé 700 selon l'invention est robuste car il permet des tolérances d'alignements entre le métal ohmique de contact, la zone dopée n+ et la tête de grille grâce à une technologie planaire. De plus, grâce à la technologie d'implantation ionique, le procédé 700 selon l'invention est précis, uniforme et reproductible.

Selon un mode de réalisation du procédé 700 selon l'invention, il est possible de réaliser l'accès de drain en plus de l'accès de source. Si le procédé 700 selon l'invention est utilisé uniquement pour l'accès de source, l'accès de drain est réalisé sans étape d'implantation de Si. En d'autres termes, l'implantation de Si est masquée en correspondance du contact de drain et le contact de drain est de type « full recess ».

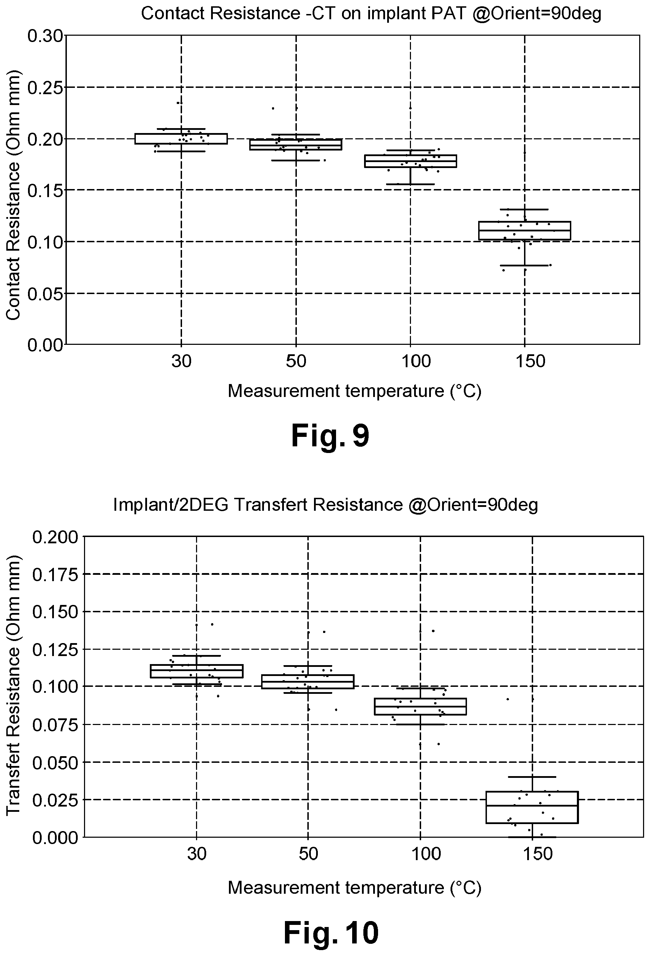

Les figures 9 à 12 illustrent la variation des différents termes contribuant à la résistance d'accès du dispositif en fonction de sa température de fonctionnement. La figure 9 montre que la résistance de contact globale Rc + Rn+ + Rt diminue avec la température de fonctionnement. Elle passe de 0.2 ohm.mm à 0.11 ohm.mm entre 30°C et 150°C, ce qui est très favorable pour la résistance de source ou drain du transistor.

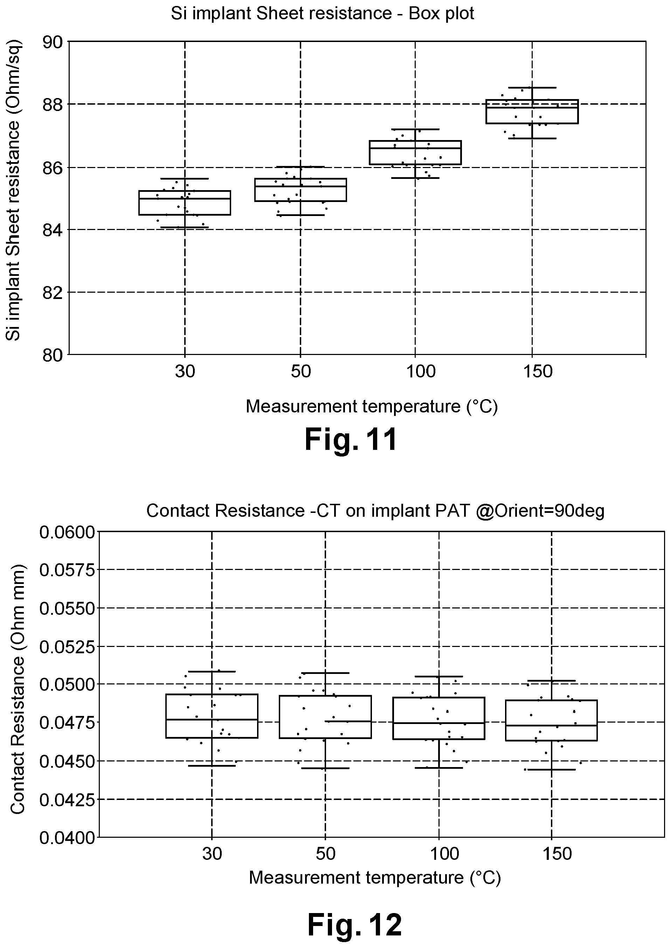

Ce comportement est dû à la forte diminution, de 0.11 à 0.024 Ohm.mm de la résistance de transition Rt avec la température, illustrée à la figure 10, alors que la résistance de la zone dopée n+ n'augmente que de 3%, comme il est montré à la figure 11 et que la résistance de contact métal/n+ reste constante et égale à environ 47 mOhm.mm, comme montré à la figure 12.

La résistance de source ou drain du transistor selon l'invention varie très peu avec la température, ce qui rend le transistor 400 selon l'invention particulièrement adapté pour des applications de puissance haute fréquence.

## Revendications

1. Transistor (400) à haute mobilité électronique comprenant :

   • un empilement de couches comprenant une couche de passivation (401) et une hétérojonction comprenant une première couche semi-conductrice (402), une deuxième couche semi-conductrice (403) et un gaz bidimensionnel d'électrons (404) à leur interface, une surface de la couche de passivation (401) étant au contact de la première couche semi-conductrice (402) ;
   • un contact métallique (405) de source et/ou un contact métallique de drain et une électrode de grille (406) ;
   • une zone dopée n+ (407) située à l'intérieur de l'hétérojonction ;

   le contact métallique (405) de source et/ou le contact métallique de drain étant positionné au niveau d'un évidement formé dans l'empilement de couches, ledit contact métallique (405) de source et/ou ledit contact métallique de drain ayant une épaisseur définie par une face supérieure (405a) et une face inférieure (405b) sensiblement parallèles au plan de couches, la face supérieure (405a) étant plane, la face inférieure (405b) étant au contact de la zone dopée n+ (407) et au-dessous de l'interface entre la première couche semi-conductrice (401) et la deuxième couche semi-conductrice (402), ledit contact métallique (405) de source et/ou ledit contact métallique de drain possédant en outre une face latérale (405c), la zone dopée n+ s'étendant depuis la face latérale du contact métallique (405) de source et/ou depuis la face latérale du contact métallique de drain vers l'électrode de grille (406) sur une longueur comprise entre 300 et 1000 nm.

2. Transistor (400) selon la revendication 1 **caractérisé en ce que** la zone dopée n+ (407) est une zone implantée possédant un profil spatial de dopage de type gaussien selon la direction normale au plan des couches.

3. Transistor (400) selon l'une des revendications précédentes **caractérisé en ce que** la face inférieure (405b) du contact métallique (405) de source et/ou la face inférieure du contact métallique de drain est au-dessous du gaz bidimensionnel d'électrons. (403).

4. Transistor (400) selon l'une des revendications précédentes **caractérisé en ce que** la distance (Lgs) entre l'électrode de grille (406) et la zone dopée n+ (407) est comprise entre 200 nm et 400 nm.

5. Transistor (400) selon l'une des revendications précédentes **caractérisé en ce que** la zone dopée n+ (407) est dopée avec un dopant de type Si ou Ge avec une concentration supérieure ou égale à $10^{20}$ cm$^{-3}$.

6. Transistor (400) selon l'une des revendications précédentes **caractérisé en ce que** la première couche semi-conductrice (402) comprend du AlGaN et la deuxième couche semi-conductrice (403) comprend du GaN.

7. Procédé de fabrication (700) d'un transistor à effet de champ à haute mobilité d'électrons comprenant les étapes suivantes :

   • fourniture (701) d'un substrat de transistor à haute mobilité d'électrons comprenant un empilement de couches comprenant une couche de passivation et une hétérojonction comprenant une première couche semi-conductrice, une deuxième couche semi-conductrice et un gaz bidimensionnel d'électrons à leur interface ;
   • formation d'une zone dopée n+ (702) par implantation ionique à l'intérieur de l'hétérojonction et recuit (703) d'activation de la zone dopée n+ ;
   • dépôt d'une couche diélectrique (704) au contact de la couche de passivation ;
   • gravure (705) de l'empilement de couches et de la couche diélectrique pour former un évidement à l'aplomb et au contact de la zone dopée n+, ledit évidement étant configuré pour accueillir un contact métallique de source et/ou drain, la face inférieure de l'évidement se situant au-dessous de l'interface entre la première couche semi-conductrice et la deuxième couche semi-conductrice ;

• dépôt d'une couche métallique (706) destinée à former le contact métallique de source et/ou le contact métallique de drain ;

• polissage mécano-chimique (707) de la couche métallique pour obtenir une surface supérieure du contact de source et/ou une surface supérieure du contact de drain planarisée ;

• définition et dépôt d'une électrode de grille (708), la zone dopée n+ s'étendant depuis une face latérale du contact métallique de source et/ou depuis une face latérale du contact métallique de drain vers l'électrode de grille sur une longueur comprise entre 300 et 1000 nm.

8. Procédé de fabrication (700) selon la revendication précédente **caractérisé en ce que** l'étape de formation de la zone dopée n+ (702) comprend une implantation monoénergétique d'ions Si ou Ge, avec une énergie d'implantation comprise entre 60 keV et 80 keV.

9. Procédé de fabrication (700) selon la revendication 7 ou la revendication 8 **caractérisé en ce que** le recuit (703) d'activation de la zone dopée n+ comprend un traitement thermique à 975°C pendant 10 heures, 1000 °C pendant trois heure ou à 1050 °C pendant une heure.

10. Procédé de fabrication (700) selon l'une des revendications 7 à 9 **caractérisé en ce qu'**il comprend en outre une étape de photolithographie pour définir une zone d'implantation destinée à accueillir la zone dopée n+.

**Fig. 1**

Ohm trop proche de la
tête de grille → Cpgs
augmente → Ft -25%

Expected edge
of ohmic metal

Ohmic Metal    Gate    Ohmic Metal

Lgs=0.64 µm    Lgd=0.77 µm

Lg=
0.11 µm

**Fig. 2**

**Fig. 3**

**Fig. 4**

**Fig. 5**

**Fig. 6**

**Fig. 7**

**Fig. 8a**

**Fig. 8b**

703

Passivation

Zone implantée

AlGaN

Zone implantée

GaN

Si HR

**Fig. 8c**

704

Diélectrique

Passivation

Zone implantée

AlGaN

Zone implantée

GaN

Si HR

**Fig. 8d**

705

Résine

Diélectrique

Passivation

AlGaN

Zone implantée

GaN

Zone implantée

Si HR

**Fig. 8e**

Diélectrique
Passivation
AlGaN
Zone implantée
GaN
Zone implantée
Si HR

**Fig. 8f**

706

Métal
Diélectrique
Passivation
AlGaN
Zone implantée
GaN
Zone implantée
Si HR

**Fig. 8g**

707

Diélectrique
Passivation
AlGaN
Zone implantée
GaN
Zone implantée
Si HR

**Fig. 8h**

708a

Métal

Diélectrique

Passivation
AlGaN

Zone implantée

GaN

Métal

Zone implantée

Si HR

**Fig. 8i**

708b

Résine

Résine

Métal

Diélectrique

Passivation
AlGaN

Zone implantée

GaN

Métal

Zone implantée

Si HR

**Fig. 8j**

708c

Résine    Résine

Métal    Métal

Zone implantée    Zone implantée

GaN

Si HR

**Fig. 8k**

708d

Métal

Métal    Métal

Zone implantée    Zone implantée

GaN

Si HR

**Fig. 8l**

708e

Métal

Zone implantée

GaN

Métal

Zone implantée

Si HR

**Fig. 8m**

708f

Métal

Métal

Zone implantée

GaN

Métal

Zone implantée

Si HR

**Fig. 8n**

708g

Résine

Métal

Métal | Métal

Zone implantée | GaN | Zone implantée

Si HR

**Fig. 8o**

708h

Métal

Métal | Métal

Zone implantée | GaN | Zone implantée

Si HR

**Fig. 8p**

Contact Resistance -CT on implant PAT @Orient=90deg

**Fig. 9**

Implant/2DEG Transfert Resistance @Orient=90deg

**Fig. 10**

Si implant Sheet resistance - Box plot

Fig. 11

Contact Resistance -CT on implant PAT @Orient=90deg

Fig. 12

Europäisches
Patentamt

European
Patent Office

Office européen
des brevets

# RAPPORT DE RECHERCHE EUROPEENNE

Numéro de la demande

**EP 22 18 3796**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | US 2015/115325 A1 (VIELEMEYER MARTIN [AT]) 30 avril 2015 (2015-04-30) * alinéa [0047] - alinéa [0070]; figures 6, 7A-7V * | 1-10 | INV. H01L29/417 H01L21/265 H01L29/08 H01L29/20 |
| Y | US 2013/299842 A1 (PRECHTL GERHARD [AT] ET AL) 14 novembre 2013 (2013-11-14) * alinéa [0041]; figures 12G, 14 * | 1-10 | H01L29/66 H01L29/778 H01L29/423 |
| Y | US 2020/373421 A1 (NIDHI NIDHI [US] ET AL) 26 novembre 2020 (2020-11-26) * alinéa [0002] * * ligne 32 - ligne 79; figures 3, 4 * | 4,5 | |

DOMAINES TECHNIQUES
RECHERCHES (IPC)

**H01L**

Le présent rapport a été établi pour toutes les revendications

| Lieu de la recherche | Date d'achèvement de la recherche | Examinateur |
|---|---|---|
| Munich | 28 novembre 2022 | Nesso, Stefano |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.....................................
& : membre de la même famille, document correspondant

EPO FORM 1503 03.82 (P04C02)

**EP 4 120 359 A1**

## ANNEXE AU RAPPORT DE RECHERCHE EUROPEENNE
## RELATIF A LA DEMANDE DE BREVET EUROPEEN NO.

EP 22 18 3796

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

28-11-2022

| Document brevet cité au rapport de recherche | Date de publication | Membre(s) de la famille de brevet(s) | Date de publication |
|---|---|---|---|
| US 2015115325 A1 | 30-04-2015 | US 2015115325 A1 | 30-04-2015 |
| | | US 2016233316 A1 | 11-08-2016 |
| US 2013299842 A1 | 14-11-2013 | CN 103426923 A | 04-12-2013 |
| | | CN 108133956 A | 08-06-2018 |
| | | DE 102013103966 A1 | 14-11-2013 |
| | | US 2013299842 A1 | 14-11-2013 |
| US 2020373421 A1 | 26-11-2020 | AUCUN | |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **B.PARVAIS et al.** GaN-on-Si mm-wave RF Devices Integrated in a 200mm CMOS Compatible 3-Level Cu BEOL. *IEDM,* 2020

- **KEISUKE SHINOHARA et al.** Scaling of GaN HEMTs and Schottky Diodes for Submillimeter-Wave MMIC Applications. *IEEE TRANSACTIONS ON ELECTRON DEVICES,* 2013, vol. 60 (10